# FASCICULE DE BREVET EUROPEEN

(11) **EP 1 843 476 B1**
(45) Date de publication et mention de la délivrance du brevet: **08.01.2014**
(21) Numéro de dépôt: 06300331.3
(22) Date de dépôt: 05.04.2006
(51) Int. Cl.: H04B 1/036, H01Q 1/24, H05K 7/20, H01Q 1/12

(54) **Antenne montée sur un mât de support comportant un amplificateur disposé à l'extérieur d'un boîtier de transmission**
Mast-montierte Antenne mit ausserhalb eines Übertragungsgehäuses angeordnetem Verstärker
Mast mounted antenna carrying an amplifier located outside of a transmission box

(43) Date de publication de la demande: 10.10.2007
(73) Titulaire: E-Blink, 91800 Boussy St. Antoine (FR)
(72) Inventeur: Rolland, Alain, Nicolas, 91480 Quincy Sous Senart (FR)
(74) Mandataire: Thinat, Michel

(56) Documents cités:
- EP-A- 1 404 024
- GB-A- 2 289 827
- US-A- 5 995 063
- US-A1- 2001 054 494

## Description

L'invention concerne un agencement de station de base d'un réseau de téléphonie mobile, du type comprenant une antenne montée sur un mât de support, un dispositif de transmission de signaux électriques, associé à l'antenne et pourvu de moyens amplificateurs de puissance et de moyens dissipateurs de chaleur, et comprenant un boîtier de transmission.

Le document US-5,995,063 divulgue une structure d'antenne comprenant un mât creux dans lequel sont logés un module radiofréquence, éventuellement un équipement de communication et des moyens de refroidissement.

Le document GB-2 289 827 divulgue une structure d'antenne comprenant un mât creux dans lequel sont logés un contrôleur de transmission de base, éventuellement un contrôleur de station de base, des alimentations et des amplificateurs de puissance.

Dans les stations de base connues, qui utilisent pour la transmission des données entre l'antenne relais et une installation fixe constituant un système de transmission de base appelé généralement BTS (Base Transceiver System) une liaison par fibre optique ou optique sans fil ou de transmission par radio-fréquences, il est connu de déporter l'amplificateur de l'installation BTS vers l'antenne. Cet amplificateur dit déporté est communément appelé amplificateur MCPA (Multi Carrier Power Amplifier). L'amplificateur MCPA souvent capable de fournir plusieurs dizaines de watts est enfermé dans un boîtier de transmission située à proximité de l'antenne. Pour dissiper la chaleur produite par l'amplificateur, ce dernier est fixé à l'intérieur du boîtier sur un dissipateur de dimensions importantes, ce qui nécessite un boîtier de dimensions souvent inacceptables dans le cadre des sites radio.

L'invention a pour but de remédier aux inconvénients des boîtiers de transmission de grande dimension, qui viennent d'être énoncés.

Pour atteindre ce but, une station de base de réseau de téléphonie mobile selon l'invention est caractérisée en ce que l'amplificateur MCPA, avec le dissipateur sur lequel il est fixé, est disposé à l'extérieur du boîtier de transmission, à un emplacement situé à proximité de celui-ci.

Selon une autre caractéristique de l'invention, l'agencement est caractérisé en ce que le boîtier de transmission, de faible taille, est disposé sous l'antenne ou intégré à celle-ci.

Selon encore une autre caractéristique de l'invention, l'agencement est caractérisé en ce que le dissipateur de chaleur est monté sur le mât de support de l'antenne.

Selon encore une autre caractéristique de l'invention, l'agencement est caractérisé en ce que le dissipateur est monté sur le mât de support de l'antenne de façon que ce mât puisse également servir de moyen dissipateur de chaleur.

Selon encore une autre caractéristique de l'invention, l'agencement est caractérisé en ce que le dissipateur avec l'amplificateur fixé sur celui-ci, est déporté et monté sur un organe de déport solidaire d'une structure de support telle qu'une structure séparée ou le mât de support de l'antenne.

Selon encore une autre caractéristique de l'invention, l'agencement est caractérisé en ce que le dissipateur est réalisé de façon à constituer le moyen de support de l'antenne et fixé sur le mât de support.

Selon encore une autre caractéristique de l'invention, l'agencement est caractérisé en ce que le boîtier de transmission et l'amplificateur sont fixés sur le dissipateur.

Selon encore une autre caractéristique de l'invention, l'agencement est caractérisé en ce que le boîtier de transmission et l'amplificateur sont enfermés dans des moyens de capot de façon à être intégrés à l'antenne.

Selon encore une autre caractéristique de l'invention, l'agencement est caractérisé en ce que l'antenne intègre le boîtier de transmission et l'amplificateur.

Selon encore une autre caractéristique de l'invention, l'agencement est caractérisé en ce que le dissipateur est entouré d'un capot de protection adapté pour créer entre ce capot et le dissipateur des canaux d'écoulement d'air de refroidissement,des moyens de capot de protection et de création de voies d'écoulement d'air pouvant également être prévu autour de l'amplificateur et du boîtier de transmission.

L'invention sera mieux comprise, et d'autres buts, caractéristiques, détails et avantages de celle-ci apparaîtront plus clairement dans la description explicative qui va suivre faite en référence aux dessins schématiques annexés donnés uniquement à titre d'exemple illustrant plusieurs modes de réalisation de l'invention et dans lesquels :
- la figure 1 est une vue en perspective, illustrant schématiquement la structure d'un système de station de base standard d'un réseau de téléphonie mobile ;
- les figures 2 et 3 sont des vues schématiques de deux variantes d'un premier mode de réalisation proposées par l'invention, de la partie A de la figure 1 ;
- la figure 4 est une vue en coupe de la partie B de la figure 2, le long de la ligne IV-IV de celle-ci ;
- la figure 5 est une vue latérale de cette partie B ;
- les figures 6 à 8 sont des vues schématiques de trois autres modes de réalisation de l'invention, et
- la figure 9 est une vue en coupe le long de la ligne IX de la figure 8.
- les figures 10 et 11 sont des vues en perspective d'un agencement selon l'invention réalisé selon le principe illustré sur les figures 2 et 5, et
- la figure 12 est une vue en perspective d'un agencement réalisé d'après le principe des figures 8 et 9.

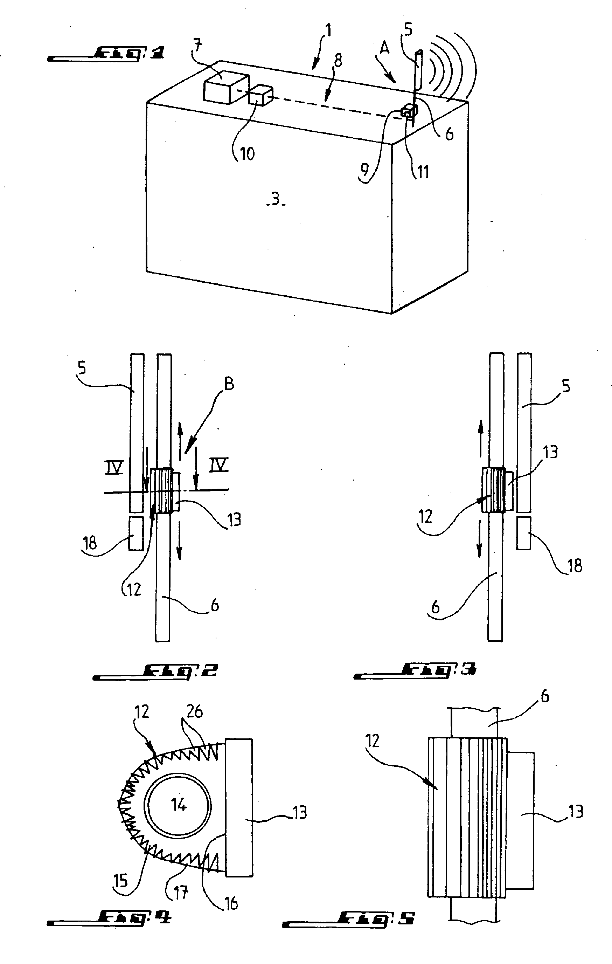

La figure 1 montre un agencement de station de base tel qu'utilisé actuellement, d'un réseau de téléphonie mobile.

Cet agencement désigné de façon générale par la référence 1 est monté sur la terrasse 2 d'un immeuble noté 3. Cet agencement classique comporte une antenne relais 5 montée sur un mât de support 6 et communique avec un ensemble fixe comportant une baie de radio communication 7 qui constitue un système de transmission de base appelé généralement BTS (Base Transceiver System), par l'intermédiaire d'une liaison de transmission de données 8. Cette liaison pourrait être du type à fibre optique, optique mais sans fil ou du type de transmission par radiofréquences. L'installation comporte du côté de l'antenne un boîtier de transmission 9 et du côté du dispositif BTS un boîtier de transmission 10. La liaison à fibre optique ou sans fil 8 est établie entre les deux boîtiers de transmission 9 et 10. Au boîtier de transmission 9, associé à l'antenne, est intégré un amplificateur de puissance connu sous la dénomination amplificateur MCPA (Multi Carrier Power Amplifier). Cet amplificateur est capable de fournir plusieurs dizaines de watts et est, à cette fin, monté, à l'intérieur du boîtier 9 sur un dissipateur devant avoir des dimensions importantes en conséquence, qui confèrent de ce fait au boîtier des grandes dimensions, souvent inacceptables dans le cadre de l'installation de sites radio.

L'invention a pour but de résoudre le problème que pose l'encombrement du boîtier de transmission utilisé actuellement.

Pour s'affranchir des contraintes dimensionnelles des boîtiers de transmission actuellement installés, l'invention propose de positionner l'amplificateur MCPA en dehors du boîtier de transmission. Lors du positionnement en dehors du boîtier de transmission, plusieurs paramètres doivent être respectés. L'amplificateur doit se situer à une très courte distance du boîtier de transmission, cette distance devant être limitée à quelques dizaines de centimètres, et l'amplificateur doit être fixé au dissipateur dont les dimensions sont en fonction des caractéristiques de l'amplificateur utilisé.

Les figures 2 à 5 illustrent un premier mode de réalisation de l'invention pour résoudre le problème qui vient d'être énoncé tout en satisfaisant aux contraintes indiquées. Dans ce mode de réalisation, le dissipateur désigné par la référence 12 et sur lequel est fixé l'amplificateur MCPA 13 est monté sur le mât de support de l'antenne, ce mât et l'antenne portant les références respectivement 6 et 5 déjà utilisées sur la figure 1. Comme le montrent plus en détail les figures 4 et 5, le dissipateur 12 est réalisé sous forme d'un corps tubulaire dont l'espace intérieur 14 est adapté à la forme du mât 6 et qui est pourvu à sa périphérie d'éléments d'augmentation de sa surface extérieure d'échange thermique, telles que des ailettes 15. L'amplificateur est monté sur une surface de pose appropriée, avantageusement plane 16. Sa position sur le dissipateur est variable. Le dissipateur peut être réalisé en aluminium, graphite ou tout autre matériau adapté et sa forme peut varier en fonction de paramètres d'installation. Le dissipateur peut, le cas échéant, être entouré d'un capot de protection 17 pour le protéger d'un contact direct avec les rayons solaires et pour améliorer le refroidissement par création de canaux d'écoulement d'air 26 entre les ailettes et le capot.

Le montage du dissipateur 12 sur le mât 6 de l'antenne présente l'avantage supplémentaire que ce mât en raison de sa taille importante pouvant aller jusqu'à plusieurs mètres peut servir aussi de dissipateur de chaleur.

Comme on le voit sur les figures 2 et 3, du fait que l'amplificateur et le dissipateur sont sortis du boîtier de transmission et donc déportés en dehors de celle-ci, ce boîtier de transmission 18 peut avoir une petite taille et être monté, conformément aux figures, sous l'antenne 5 et même être intégré à celle-ci.

Les figures 2 et 3 montrent spécifiquement deux variantes d'exécution, dans celle de la figure 2, l'amplificateur 13 est positionné sur une face de pose du dissipateur, qui est détourné de l'antenne 5, tandis que, sur la figure 3, l'amplificateur est situé entre l'antenne 5 et le dissipateur 12 et ainsi entre l'antenne et son mât de support 6.

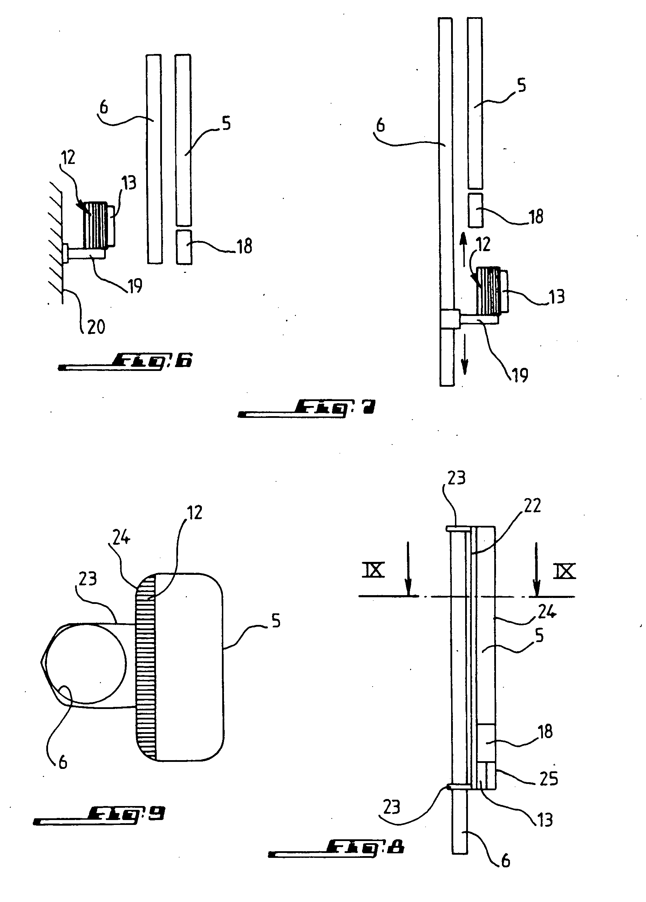

Les figures 6 et 7 illustrent un mode de réalisation de l'invention selon lequel l'amplificateur MCPA 13 et le dissipateur 12 sont déportés et fixés sur un organe porteur avantageusement de forme cylindrique ou parallélépipédique 19, fixé sur un support séparé 20 comme sur la figure 6 ou sur le mât 6, conformément à la figure 7. Cette dernière variante présente l'avantage de permettre une variation de la position de l'ensemble dissipateur-amplificateur par déplacement du support 19, axialement sur le mât 6.

Dans le cadre du mode de réalisation selon les figures 6 et 7, le support du dissipateur pourrait être un mât qui n'est pas le mât de support de l'antenne. Ce mât, qui constitue ainsi un mât de déport, pourrait être fixé sur le mât 6 de support de l'antenne au moyen d'un organe approprié, telle qu'une bride, platine ou autre.

Comme le montrent les figures, ce mode de réalisation aussi permet d'avoir un boîtier de transmission de petite taille qui peut être placé sous l'antenne ou même intégré à celle-ci.

Les figures 8 et 9 présentent encore un autre mode de réalisation selon lequel le dissipateur est intégré à l'antenne. Dans l'exemple de mise en oeuvre de cette solution proposée par l'invention, le dissipateur portant maintenant la référence 22 est réalisé sous forme d'une plaque de support de l'antenne 5 et fixé au mât 6 de toute façon appropriée, par exemple par des brides 23 disposées respectivement en haut et en bas de la plaque de support. L'amplificateur MCPA 13 est fixé sur le dissipateur, en dessous de l'antenne 5, le boîtier de transmission 18, de petite taille, étant également fixé sur le dissipateur entre l'antenne et l'amplificateur.

Un capot 24 pourrait être prévu pour protéger le dissipateur d'un contact direct avec les rayons solaires. Il est possible d'intégrer le boîtier de transmission 18 dans l'antenne, au moyen d'un capot pouvant être le capot de protection du dissipateur. Comme le montre la figure 8, l'amplificateur 13 qui est fixé sur le dissipateur peut également être intégré dans l'antenne par l'intermédiaire d'un capot supplémentaire 25 ou, le cas échéant, par le capot 24. Il est à noter que l'antenne elle-même peut intégrer le dissipateur et ses fixations, au lieu de se fixer sur le dissipateur. On entend par intégration le fait de faire partie de l'antenne ou d'être associé à celle-ci au moyen d'un capot s'associant à l'antenne.

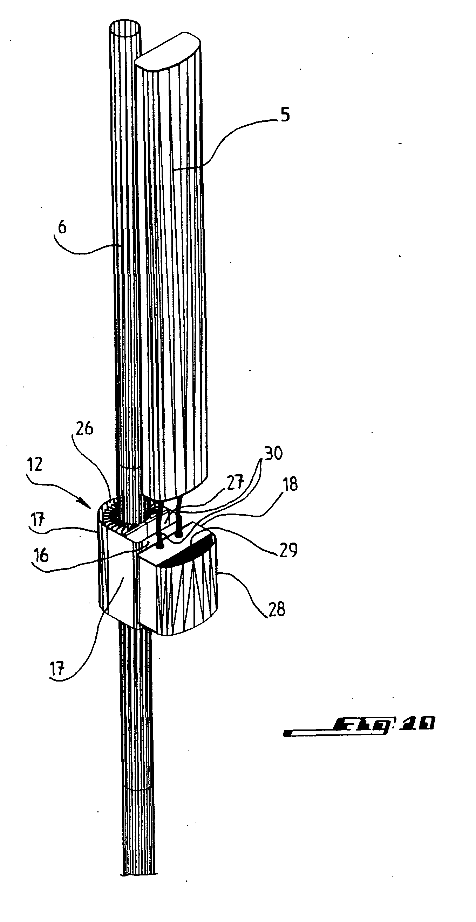

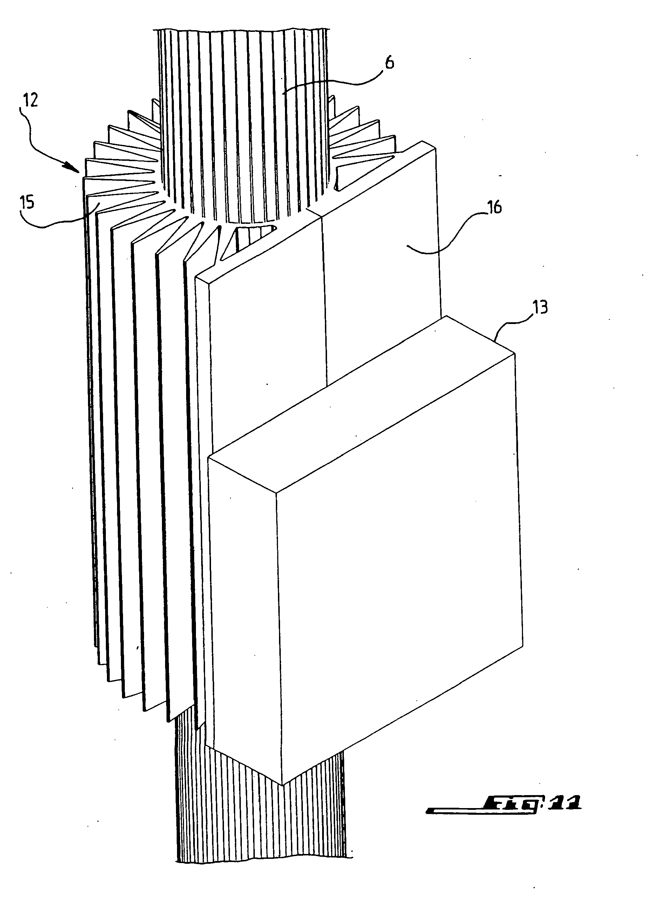

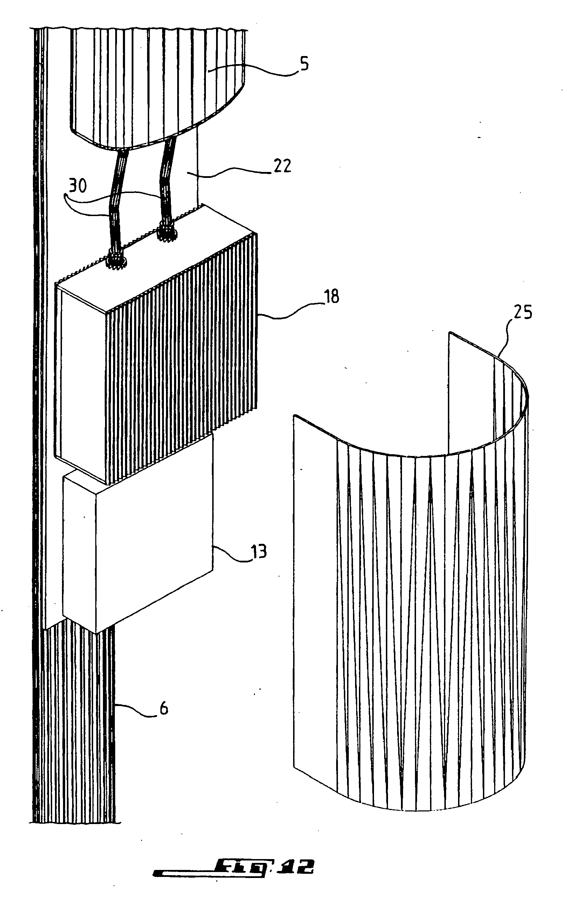

L'invention a été décrite ci-avant en se reportant aux dessins schématiques. Les figures 10 à 12 sont des vues en perspective d'exemples plus concrets de la mise en oeuvre de l'invention. Les figures 10 et 11 montrent un agencement selon l'invention construit selon le principe représenté sur les figures 2 et 3, tandis que la figure 12 montre un agencement selon l'invention établi selon le principe des figures 8 et 9.

Ces figures font clairement apparaître ce qui est déjà indiqué sur les figures schématiques. On reconnaît notamment sur la figure 10 les canaux 26 d'écoulement d'air de refroidissement entre le dissipateur 12 et le capot 17 entourant ce dernier. En s'étendant vers l'avant au-delà de la face de pose 16 du dissipateur, le capot crée un espace 27 recouvrant également l'amplificateur 13 monté sur la face 16, comme on le voit sur la figure 11. Cet espace peut également constituer, le cas échéant, une voie d'écoulement d'air de refroidissement. La figure 10 montre en outre qu'un capot 28 peut être associé au boîtier de transmission 18 qui, en étant bombé, établit un espace 29 qui engendre également un écoulement d'air. La figure 10 confirme que le déport de l'amplificateur et de son dissipateur permet de résoudre le problème de l'encombrement que posent les boîtes de transmission utilisées jusqu'à présent. En effet, dans l'exemple représenté, la largeur du boîtier 18 correspond à celle de l'antenne 5. L'ensemble formé par le boîtier de transmission 18 disposé devant le capot 17, d'une part, et le dissipateur 12 et l'amplificateur 13, entourés par la capot 17, d'autre part, forment un ensemble compact et de faibles dimensions en dessous de l'antenne, la référence 30 désignant les connexions électriques entre l'antenne et le boîtier. La réduction des dimensions du boîtier de transmission 18 est faite de façon qu'elle correspond à celle de l'antenne 5.

## Revendications

1. Agencement de station de base d'un réseau de téléphonie mobile, du type comprenant une antenne montée sur un mât de support, à l'extérieur de celui-ci, un dispositif de transmission de données, associé à l'antenne et pourvu de moyens d'amplificateurs de puissance et de moyens dissipateurs de chaleur et comportant un boîtier de transmission, **caractérisé en ce que** l'amplificateur (13), avec le dissipateur (12) sur lequel il est fixé, est disposé à l'extérieur du boîtier de transmission (18).

2. Agencement selon la revendication 1, **caractérisé en ce que** le boîtier de transmission (18) dont la taille est réduite du fait que les moyens amplificateurs (13) et les moyens dissipateurs (12) ont été sortis du boîtier, est disposé sous l'antenne (5) ou intégré à celle-ci.

3. Agencement selon l'une des revendications 1 ou 2, **caractérisé en ce que** le dissipateur de chaleur (12) est monté sur le mât de support (6) de l'antenne (5).

4. Agencement selon la revendication 3, **caractérisé en ce que** le dissipateur (12) est monté sur le mât (6) de support de l'antenne (5) de façon que ce mât puisse également servir de moyen dissipateur de chaleur.

5. Agencement selon l'une des revendications 1 ou 2, **caractérisé en ce que** le dissipateur (12), avec l'amplificateur (13) fixé sur celui-ci, est déporté et monté sur un organe de déport (19) solidaire d'une structure de support telle qu'une structure séparée (20) ou lé mât (6) de support de l'antenne.

6. Agencement selon la revendication 5, **caractérisé en ce que** le dissipateur (22) est réalisé de façon à constituer le moyen de support de l'antenne (5) et fixé sur le mât (6) de support.

7. Agencement selon la revendication 6, **caractérisé en ce que** le boîtier de transmission (18) et l'amplificateur (13) sont fixés sur le dissipateur (12).

8. Agencement selon la revendication 7, **caractérisé en ce que** le boîtier de transmission (18) et l'amplificateur (13) sont enfermés dans des moyens de capot de façon à être intégrés à l'antenne.

9. Agencement selon l'une des revendication 1 ou 2, **caractérisé en ce que** l'antenne intègre le boîtier de transmission (18) et l'amplificateur (13).

10. Agencement selon l'une des revendications 1 à 9, **caractérisé en ce que** le dissipateur (12) est entouré d'un capot de protection (17) adapté pour créer entre ce capot et le dissipateur des canaux d'écoulement d'air de refroidissement (26), des moyens de capot de protection et de création de voies d'écoulement d'air pouvant également être prévu autour de l'amplificateur (13) et du boîtier de transmission (18).

11. Agencement selon l'une des revendications 1 à 10, **caractérisé en ce que** l'amplificateur (13) est situé à une courte distance du boîtier de transmission (18), de l'ordre de quelques dizaines de centimètres.

## Patentansprüche

1. Basisstationsanordnung eines Mobilfunknetzes, von der Art umfassend eine Antenne, die außen an einem Stützmast montiert ist, eine Datenübertragungsvorrichtung, die mit der Antenne verknüpft ist und mit Leistungsverstärkungsmitteln und Wärme ableitenden Mitteln versehen ist und ein Übertragungsgehäuse umfasst, **dadurch gekennzeichnet, dass** der Verstärker (13) mit dem Wärmeableiter (12), an dem er befestigt ist, außerhalb des Übertragungsgehäuses (18) angeordnet ist.

2. Anordnung nach Anspruch 1, **dadurch gekennzeichnet, dass** das Übertragungsgehäuse (18), dessen Größe dadurch reduziert ist, dass die Verstärkungsmittel (13) und die Wärmeableitungsmittel (12) aus dem Gehäuse genommen wurden, unter der Antenne (5) angeordnet oder in diese integriert ist.

3. Anordnung nach einem der Ansprüche 1 oder 2, **dadurch gekennzeichnet, dass** der Wärmeableiter (12) auf dem Stützmast (6) der Antenne (5) montiert ist.

4. Anordnung nach Anspruch 3, **dadurch gekennzeichnet, dass** der Wärmeableiter (12) auf dem Stützmast (6) der Antenne (5) derart montiert ist, dass dieser Mast auch als Wärmeableitungsmittel dienen kann.

5. Anordnung nach einem der Ansprüche 1 oder 2, **dadurch gekennzeichnet, dass** der Wärmeableiter (12), zusammen mit dem daran befestigten Verstärker (13), abgesetzt ist und auf einem abgesetzten Element (19) montiert ist, das mit der Stützstruktur, wie etwa mit einer getrennten Struktur (20) oder dem Stützmast (6) der Antenne, einstückig ist.

6. Anordnung nach Anspruch 5, **dadurch gekennzeichnet, dass** der Wärmeableiter (22) derart ausgebildet ist, dass er das Stützmittel der Antenne (5) bildet und an dem Stützmast (6) befestigt ist.

7. Anordnung nach Anspruch 6, **dadurch gekennzeichnet, dass** das Übertragungsgehäuse (18) und der Verstärker (13) an dem Wärmeableiter (12) befestigt sind.

8. Anordnung nach Anspruch 7, **dadurch gekennzeichnet, dass** das Übertragungsgehäuse (18) und der Verstärker (13) in Kappenmitteln eingeschlossen sind, um mit der Antenne integriert zu werden.

9. Anordnung nach einem der Ansprüche 1 oder 2, **dadurch gekennzeichnet, dass** die Antenne das Übertragungsgehäuse (18) und den Verstärker (13) integriert.

10. Anordnung nach einem der Ansprüche 1 bis 9, **dadurch gekennzeichnet, dass** der Wärmeableiter (12) von einer Schutzkappe (17) umgeben ist, die dazu geeignet ist, um zwischen dieser Kappe und dem Wärmeableiter Kühlluft-Strömungskanäle (26) zu erstellen, wobei Schutzkappenmittel und Mittel zum Erstellen von Luftströmungswegen auch um den Verstärker (13) und das Übertragungsgehäuse (18) herum bereitgestellt werden können.

11. Anordnung nach einem der Ansprüche 1 bis 10, **dadurch gekennzeichnet, dass** sich der Verstärker (13) in einem geringen Abstand, von etwa mehreren Dutzend Zentimetern, von dem Übertragungsgehäuse (18) befindet.

## Claims

1. A base station arrangement of a mobile communications network, of the type comprising an antenna mounted outside a supporting mast, a data transmission device associated with the antenna and provided with power amplification means and heat sink means, and comprising a transmission box, **characterized in that** the amplifier (13), together with the heat sink (12) to which it is fastened, is arranged outside the transmission box (18).

2. The arrangement according to claim 1, **characterized in that** the transmission box (18), the size of which is reduced due to the amplification means (13) and the heat sink means (12) being located outside the box, is arranged under the antenna (5) or integrated therewith.

3. The arrangement according to any of claims 1 or 2, **characterized in that** the heat sink (12) is mounted on the supporting mast (6) of the antenna (5).

4. The arrangement according to claim 3, **characterized in that** the heat sink (12) is mounted on the supporting mast (6) of the antenna (5) so that this mast can also act as a heat sink means.

5. The arrangement according to any of claims 1 or 2, **characterized in that** the heat sink (12), together with the amplifier (13) fastened thereto, is remote and mounted on a remote member (19) integral with a supporting structure such as a separate structure (20) or the supporting mast (6) of the antenna.

6. The arrangement according to claim 5, **characterized in that** the heat sink (22) is made so as to be the means supporting the antenna (5) and is fastened to the supporting mast (6).

7. The arrangement according to claim 6, **characterized in that** the transmission box (18) and the amplifier (13) are fastened to the heat sink (12).

8. The arrangement according to claim 7, **characterized in that** the transmission box (18) and the amplifier (13) are enclosed inside hood means so as to be integrated with the antenna.

9. The arrangement according to any of claims 1 or 2, **characterized in that** the antenna integrates the transmission box (18) and the amplifier (13).

10. The arrangement according to any of claims 1 to 9, **characterized in that** the heat sink (12) is surrounded by a protective housing (17) adapted for creating between this housing and the heat sink cooling air flow channels (26), wherein protective housing and air flow path creating means can also be provided around the amplifier (13) and the transmission box (18).

11. The arrangement according to any of claims 1 to 10, **characterized in that** the amplifier (13) is located at a short distance from the transmission box (18), on the order of several tens of centimeters.
